**Europäisches Patentamt**

**European Patent Office**

**Office européen des brevets**

(19)

(11) Veröffentlichungsnummer: **0 126 784**
**B1**

(12) **EUROPÄISCHE PATENTSCHRIFT**

(45) Veröffentlichungstag der Patentschrift:
**04.10.89**

(51) Int. Cl.⁴: **G 11 C 8/00**

(21) Anmeldenummer: **83105171.9**

(22) Anmeldetag: **25.05.83**

(54) **Halbleiterspeicher.**

(43) Veröffentlichungstag der Anmeldung:
**05.12.84 Patentblatt 84/49**

(45) Bekanntmachung des Hinweises auf die Patenterteilung:
**04.10.89 Patentblatt 89/40**

(84) Benannte Vertragsstaaten:
**DE FR GB**

(56) Entgegenhaltungen:
**EP-A-0 050 022**
**EP-A-0 072 763**
**EP-A-0 096 359**
**DE-B-2 523 853**
**US-A-3 736 574**

(73) Patentinhaber: **IBM DEUTSCHLAND GMBH,**
**Pascalstrasse 100, D-7000 Stuttgart 80 (DE)**

(84) Benannte Vertragsstaaten: **DE**

(73) Patentinhaber: **International Business Machines**
**Corporation, Old Orchard Road, Armonk, N.Y.**
**10504 (US)**

(84) Benannte Vertragsstaaten: **FR GB**

(72) Erfinder: **Wiedmann, Siegfried, Dr., Dipl.- Ing., Im**
**Himmel 64A, D-7000 Stuttgart 80 (DE)**

(74) Vertreter: **Rudolph, Wolfgang, Dipl.- Ing., IBM**
**Deutschland GmbH Schönaicher Strasse 220,**
**D-7030 Böblingen (DE)**

EP 0 126 784 B1

LIBER, STOCKHOLM 1989

## Beschreibung

Die Erfindung betrifft einen Halbleiterspeicher nach dem Oberbegriff des Patentanspruchs 1.

Halbleiterspeicher mit Speicherzellen in bipolarer oder MTL-Technik sind prinzipiell bekannt. In der DE-OS-2 855 866 ist ein Entladeverfahren für derartige Speicher beschrieben, um die Entladung von kapazitiven Strömen auf bestimmten Leitungen zu ermöglichen, damit ein schnelleres Schreiben bzw. Lesen möglich ist. MTL-Speicherzellen sind beispielsweise in der DE-PS-2 612 666 beschrieben.

Außerdem ist es sowohl bei bipolaren Speichern als auch bei FET-Speichern üblich, die Zeilen- oder Wortleitungen in zwei Teile zu teilen. Ein solcher Speicher ist z. B. in der DE-OS-2 548 564 beschrieben. Dieser Speicher ist dadurch gekennzeichnet, daß die Zeilenleitungen jeweils rechte und linke Zeilenleitungsabschnitte aufweisen, daß einer der Zahl der Zeilenleitungen entsprechende Anzahl von Abtastverstärkern in einer Spalte derart angeordnet ist, daß jeder der Verstärker einen rechten Zeilenleitungsabschnitt mit einem linken Zeilenleitungsabschnitt verbindet, daß die Speicherzellen jeweils einen Feldeffekttransistor, dessen Gate an einer der Spaltenleitungen und dessen Source- oder Drainanschluß an einer der Zeilenleitungen angeschaltet sind, und ein kapazitives Speicherelement aufweisen, daß ferner mehrere Hilfszellen vorgesehen sind, von denen jeweils eine mit einem der rechten oder linken Zeilenleitungsabschnitte verbunden ist, und daß eine Eingangs/Ausgangs-Sammelleitung an einem Ende der Zeilenleitungen angeordnet und mit diesem verbunden ist, wobei die Sammelleitung mit einigen der Speicherzellen für die Abtastverstärker koppelbar ist. Dadurch, daß die Wortschaltkreise in der Mitte von der linken und der rechten Wortleitung angeordnet sind, wird die effektive Wortleitungskapazität halbiert. Trotzdem ist insbesondere für Speicher mit einer sehr großen Anzahl von Speicherzellen pro Wortleitung diese Wortleitungskapazität noch zu hoch, so daß sich ein derartiger Vorschlag für höchstintegrierte Speicher mit sehr hoher Informationsspeicherkapazität nicht eignet. Dadurch, daß die Wortleitungen erst nach dem Entladen selektiert werden können, tritt ein Geschwindigkeitsverlust auf, außerdem sind sehr große kapazitive Ströme vorhanden, die eine erhöhte Verlustleistung und Störprobleme innerhalb der Matrix hervorrufen.

Die aus EP-A-0 050 022 bekannte Lösung, die gesamte Speichermatrix in mehrere Teilmatrizen aufzuteilen, ist wegen des mehrfachen Bedarfs an Peripherieschaltkreisen, die eine wesentlich größere Fläche, höhe Verlustleistung und eine sehr komplizierte Verdrahtung der Teilmatrizen erfordern, nicht vorteilhaft für die Höchstintegration.

Eine andere Lösung zur Verringerung der Verlustleistung und zur Wirksammachung nur bestimmter benötigter Teile des Speichers ist in der DE-PS-2 001 697 beschrieben. Hier ist ein Datenspeicher mit einer Vielzahl von Speicherplätzen, einem Adressenregister und einer Dekodiereinrichtung zur Adressierung jeweils eines Speicherplatzes zwecks Auslesens gespeicherter Informationen oder zwecks Einschreibens von Informationen bekannt geworden, der dadurch charakterisiert ist, daß die Dekodiereinrichtung einen Hauptdekoder, der über Adressensignalleitungen mit dem Adressenregister verbunden ist, und eine Gruppe von dem Hauptdekoder nachgeordneten Dekodern aufweist, die alle parallel an weitere Adressensignalleitungen des Adressenregisters angeschlossen sind, und daß jedem der nachgeordneten Dekoder eine Schalteinrichtung zum wahlweisen Anschalten des betreffenden Dekoders an die Betriebsspannung zugeordnet ist und jeder der Ausgangsleitungen des Hauptdekoders mit einem Steueranschluß der Schalteinrichtung eines der nachgeordneten Dekoder verbunden ist, derart, daß wenn die Dekodiereinrichtung durch das Adressenregister angesteuert wird, durch ein auf einer der Ausgangsleitungen des Hauptdekoders erscheinendes Signal jeweils nur derjenige nachgeordnete Dekoder als einziger in Tätigkeit gesetzt wird, dessen Schalteinrichtung an die jeweils betreffende Ausgangsleitung angeschlossen ist. Auch diese Schaltung hat jedoch den Nachteil, daß die Leitungskapazitäten noch nicht genügend reduziert werden, um schnelle Zugriffszeiten bei höchstintegrierten Speichern mit sehr hoher Speicherkapazität zu ermöglichen.

Um die Speicherkapazität eines Speichers auf das Doppelte zu erhöhen, wurde in der Europäischen Anmeldung 81 109 372 (EP-A-0 078 338) eine Lösung für Feldeffekt-Transistorspeicher bekannt, bei dem die Ausgänge der Abfühlverriegelungsschaltung mit zwei Paaren kreuzgekoppelter Ladungsspeicherelemente als Bitleitungs-Koppeltransistoren verbunden sind und bei dem mit den Ladungskopplungselementen um das Doppelte erweiterte Bitleitungspaare verbunden sind. Außerdem ist eine zusätzliche Bitleitung zur Ansteuerung der zusätzlichen Speicherzellen in getrennten Abschnitten angeordnet, wobei jeder Abschnitt seine eigenen Referenzzellen aufweist und mit der Abfühlverriegelungsschaltung über als kapazitätsarme Leitungen ausgebildete Schichten und Ladungskopplungselemente verbunden ist. Obwohl hier unter Verwendung einer zweiten Metallisierungsschicht für die Verdrahtung und der Selbstisolierungscharakteristiken der als Leseverstärker dienenden Verriegelungsschaltungen eine Verdoppelung der Anzahl der Bits pro Bitleitung erreicht wird, ohne daß die Zellgröße erhöht werden muß und ohne daß sich ein Lesesignal unzulässig soweit verkleinert, daß ein größerer Aufwand in den Peripherieschaltkreisen erforderlich ist, ist eine Erweiterung der Wortleitungen und der damit spezifisch in Verbindung stehenden Probleme weder gezeigt noch angedeutet, so daß sich auch diese Lösung nicht für Speicher mit sehr hoher Speicherkapazität in Höchstintegrationstechnik eignet.

Aus der DE-P-2 523 853 sind ein Verfahren und eine Schaltungsanordnung zum Betreiben eines Informationsspeichers, dessen Speicherzellen und Ansteuerschaltungen aus bipolaren Transistoren bestehen, bekannt geworden.

Die Ansteuerschaltungen, insbesondere die Decoder sind dabei zweistufig ausgeführt und mit einer Ansteuerschaltung verbunden, die den Anfang und das Ende einer Selektionsphase unter Steuerung des Taktes festlegt.

Die Decoder befinden sich dabei sowohl im selektierten als auch im nicht selektierten Zustand unter voller Spannung, wobei der Strom zu Anfang der Selektionsphase überproportional ansteigt, dann auf einen Reststrom absinkt, um die Decoder im selektierten Zustand zu halten. Am Ende eines Selektionszyklus werden die Decoder sofort in den nichtselektierten Zustand gesteuert. Durch das Erhöhen der Integrationsdichte, das Verringern der Lese-/Schreibzeiten und damit der Zykluszeit des Speichers sowie durch das Verringern der Verlustleistung unter Berücksichtigung einer möglichst .günstigen monolithischen Struktur der Speicherzellen mit den Ansteuerschaltungen, wurde hier ein Informationsspeicher geschaffen, der trotz des geringen Strombedarfs Zykluszeiten im echten Nanosekundengebiet bei der Anwendung der bisher bekannten Planartechnik ermöglicht. Dies ist in erster Linie dadurch erreicht worden, daß die Decoder mehrstufig aufgebaut worden sind und die erforderlichen Ströme gesteuert werden. Innerhalb der Speichermatrix ist jedoch nichts verändert worden, da diese Maßnahmen sich ausdrücklich nur auf die Peripherieschaltkreise beziehen.

In der EP-A-0 096 359, die unter Art. 54, § 3 EPÜ fällt, ist ein integrierter Halbleiterspeicher beschrieben, dessen Speicherzellen ausschließlich aus Feldeffekttransistoren bestehen.

Bei diesem Halbleiterspeicher sind die Wortleitungen in mehrere Teilwortleitungen unterteilt, die durch AND-Gates gesteuert werden. Dabei handelt es sich bei dem AND-Gates um ein logisches Verknüpfungselement, dessen Ausgangssignal zwar von den Eingangssignalen bestimmt wird, aber vom Versorgungspotential regeneriert wird.

Der Erfindung liegt deshalb die Aufgabe zugrunde, einen Halbleiterspeicher mit sehr hoher Speicherkapazität, äußerst kurzer Zugriffszeit und kleinster Verlustleistung in Höchstintegrationstechnik zu schaffen, dessen wirksame Wortleitungskapazitäten trotz wesentlicher Erweiterung der Wortleitungen, d.h. Erhöhung der Anzahl Bits pro "herkömmlicher" Wortleitung, in einer Speicherzellenmatrix, verringert wird.

Die Lösung der Aufgabe besteht im Kennzeichen des Patentanspruchs 1.

Weitere Ausgestaltungen der Lösung sind in den Kennzeichen der Unteransprüche charakterisiert.

Mit der vorliegenden Lösung wird ein Schaltungskonzept vorgeschlagen, das die oben beschriebenen Nachteile vermeidet.

Durch die Aufteilung der Wortleitungen in mehrere Teilwortleitungen und die Einfügung von separat ansteuerbaren Wortschaltern für jede Teilwortleitung beträgt die effektiv wirksame Wortleitungskapazität jetzt nur 1/N der gesamten effektiven Wortleitungskapazität ohne Unterteilung. Für typische N-Zahlen von 8 oder 16 läßt sich dadurch das Leistungs-/Geschwindigkeits-Verhältnis der Speicherzellenselektion mühelos um eine ganze Größenordnung verbessern. Der zusätzliche Platzbedarf für die mehrfach vorhandenen Worttreiber-Transistoren ist vernachlässigbar klein, wenn an einer Teilwortleitung z. B. 16 Speicherzellen angeordnet sind. Bemerkenswert ist außerdem, daß bei MTL-Speichern die Wortschalter in die Wanne der Speicherzellen eingeschlossen werden können, um den Platzbedarf weiter zu verringern. Die zusätzliche Wortansteuerleitung, die parallel zu den geteilten Wortleitungen verläuft und die alle Wortschalter eines Wortes gemeinsam ansteuert, benötigt insbesondere in MTL-Technik und auch bei Mehrlagenmetallisierung praktisch keinen zusätzlichen Platz. Hinzu kommt, daß die Wortschalter-Transistoren wegen des kleinen Stroms nicht als Leistungstransistoren, sondern als sog. Minimum-Transistoren ausgeführt werden können. Bei den MTL-Speichern lassen sie sich mit den Speicherzellen in derselben Wanne integrieren. Ein großer Vorteil besteht noch darin, daß der Spannungsabfall entlang der Wortleitung wegen des kleinen Stroms und der tatsächlich sehr kurzen Länge sehr wesentlich reduziert wird. Dadurch kann mit kleinen Wortleitungsschaltpegel-Unterschieden gearbeitet werden. Die Störverhältnisse werden auf den Leitungen für das Gesamtchip wesentlich reduziert, so daß sich die gesamten Leistungsgrenzen eines derartigen Chips bedeutend verbessern. Außerdem lassen sich, wie gezeigt, mehrere X-Wortansteuerleitungen zusammenfassen, indem die Anschlüsse an die Y-Wortansteuerleitungen entsprechend aufgeteilt werden und die Zahl der Y-Wortsteuerleitungen entsprechend erhöht wird. Durch diese Möglichkeit wird ein zusätzlicher Freiheitsgrad für eine optimale Aufspaltung der Wortleitungen im gesamten Speicher-Array erzielt. Außerdem wird die Last für die Treiber der X- und Y-Ansteuerleitungen optimal umverteilt und damit ein äußerst gutes Geschwindigkeits-/Leistungsverhältnis des Speichers erzielt. Außerdem ist der Flächenaufwand für das Speicherzellen-Array und die Peripherieschaltkreise bei bestimmter Geschwindigkeit minimal, da man die Leiterbreiten nicht vergrößern muß, sondern auch für sehr lange Selektionsleitungen aufgrund der reduzierten Ströme mit Minimal-Leiterbreiten auskommt.

Die Erfindung wird anhand eines in den Zeichnungen dargestellten Ausführungsbeispiels näher erläutert.

Es zeigen:

Fig. 1 ein Prinzipschaltbild eines Speicher-Arrays mit unterteilten Wortleitungen;

Fig. 2 ein Prinzipschaltbild, das zeigt, daß das Prinzip nach Fig. 1 auch für Speicherzellen-Arrays mit positivem Wortleitungs-Selektionsimpuls angewandt werden kann;

Fig. 3 ein Prinzipschaltbild einer Speichermatrix mit geteilten Wortleitungen und zusammengefaßten X-Wortansteuerleitungen und

Fig. 4 eine Speichermatrix mit geteilten Wortleitungen und zusammengefaßten Y-Wortansteuerleitungen.

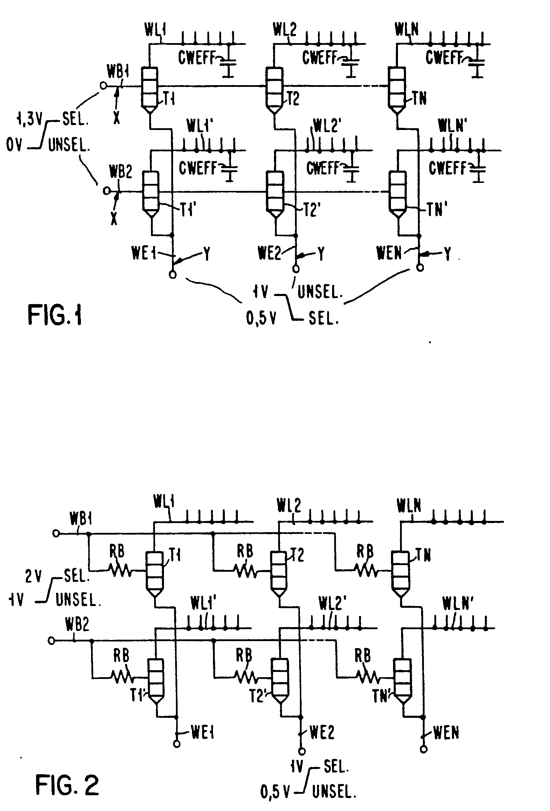

Das in Fig. 1 gezeigte Schaltbild zeigt eine wortorganisierte Speichermatrix mit geteilten Wortleitungen WL und zusätzlichen Wortansteuerleitungen WB und WE. Die Wortleitungen WL der gesamten Speicherzellenmatrix sind in mehrere geteilte Wortleitungen WL1, WL2, ..., WLN aufgeteilt, und jede Teilwortleitung wird von einem separaten Wortschalter in Form eines Transistors T1, T2, ..., TN angesteuert. Parallel zu den geteilten Wortleitungen WL1, WL2, ..., WLN wird jeweils eine zusätzliche Wortansteuerleitung WB in die Speicherstruktur eingeführt, die alle Wortschalter T1, T2, ..., TN eines Wortes gemeinsam ansteuert. Hinzu kommt noch für jede durch eine geteilte Wortleitung WL1, WL2, ..., WLN gesteuerte Wortgruppe eine weitere, im allgemeinen dazu senkrecht verlaufende Wortansteuerleitung WE. Bei Mehrlagentechnik können die beiden X-Y-Wortansteuerleitungen in getrennten Lagen angebracht werden und dann parallel zueinander verlaufen. Die Selektion einer einzelnen Teilwortleitung, z. B. WL1, erfolgt durch eine X-Y-Ansteuerung des jeweiligen Wortschalters, z. B. T1, mit Hilfe der entsprechenden Wortansteuerleitungen, z. B. WB1 und WE1. Durch diese Schaltungsmaßnahme beträgt jetzt die effektive Wortleitungskapazität nur noch $\frac{1}{N}$ der gesamten effektiven Wortleitungskapazität eines bisherigen Speichers ohne die hier gezeigte Wortleitungsunterteilung.

Für typische Größenordnungen von N, z. B. 8 oder 16, läßt sich das Leistungs-/Geschwindigkeits-Verhältnis eines solch aufgebauten Halbleiterspeichers um eine ganze Größenordnung verbessern. Der zusätzliche Platzbedarf für die mehrfachen Worttreiber-Transistoren ist vernachlässigbar klein, wenn man einer Teilwortleitung z. B. 16 Speicherzellen zuordnet. Z.B. können bei MTL-Speichern die Wortschalter mit in die Wanne der Speicherzellen eingeschlossen werden, was außerdem den Gesamtplatzbedarf weiter verringert.

In Fig. 2 ist ein weiteres Ausführungsbeispiel dargestellt, das zeigen soll, daß das in Verbindung mit Fig. 1 beschriebene Prinzip der Wortleitungsunterteilung auch auf Speicherzellen-Arrays mit positivem Wortleitungs-Selektionsimpuls, wie z. B. bipolare kreuzgekoppelte Multi-Emitter-Transistorzellen, angewandt werden kann. Der schaltungsmäßige Unterschied zur Schaltung nach Fig. 1 besteht hier lediglich darin, daß die Wortansteuerleitungen WB1, WB2, ... nicht direkt auf die Basis der Wortschalter T1, T2,..., TN geführt sind, sondern über einen Widerstand RB zur Entkopplung von selektierten und unselektierten Wortansteuerleitungen, z. B. WB1, WB2 bzw. WE1, WE2. Anstelle der hier für die Wortschalter verwendeten NPN-Transistoren können auch PNP-Transistoren verwendet werden.

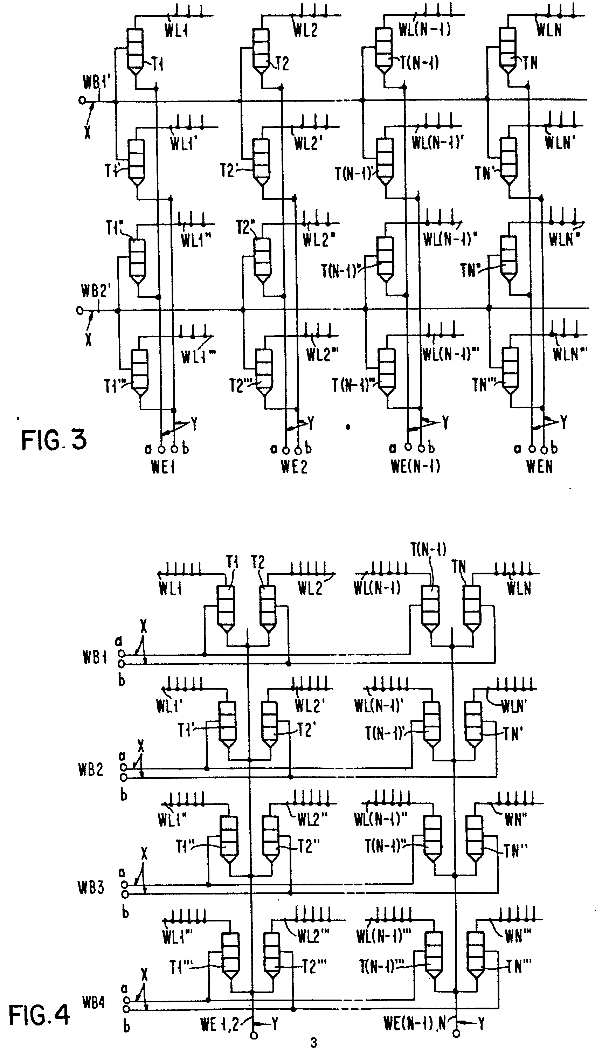

In Fig. 3 ist ein weiteres modifiziertes Ausführungsbeispiel eines Halbleiterspeichers dargestellt, bei dem zwei oder mehrere X-Wortansteuerleitungen zusammengefaßt sind, indem die Anschlüsse an die Y-Wortansteuerleitungen entsprechend aufgeteilt werden und die Zahl der Y-Wortansteuerleitungen entsprechend erhöht wird. Eine X-Wortansteuerleitung, z. B. WB1', ist deshalb mit den Basen von mindestens zwei Wortschaltern T1 und T1' verbunden, während die Y-Wortansteuerleitungen WE1a, b je mit dem Emitter eines zu dieser X-Wortansteuerleitung WB1' gehörenden Wortschalters T1 bzw. T1' verbunden sind. Durch diese Möglichkeit wird ein zusätzlicher Freiheitsgrad für eine optimale Aufspaltung der Wortleitungen im gesamten Speicher-Array erzielt. Eine vorteilhafte Anwendung dieses Schaltungsprinzips wird z. B. erreicht, wenn aufgrund der vorgegebenen Speicherzellenmatrix sehr wenig Platz für die zusätzlichen X-Ansteuerleitungen WB vorhanden ist, aber andererseits die Unterbringung von zusätzlichen Y-Ansteuerleitungen WEa, b mit geringem Aufwand möglich ist. Ein weiterer Vorteil besteht darin, daß man die Last für die Treiber der X- und Y-Ansteuerleitungen optimal umverteilen kann und damit auch ein optimales Geschwindigkeits-/Leistungs-Verhältnis eines Speichers bei vorgegebenen Bedingungen erzielen kann.

In Fig. 4 ist eine weitere Variante des Schaltungsprinzips dargestellt, das bei umgekehrten Ausgangsverhältnissen zu Fig. 3 sehr vorteilhaft angewandt werden kann. Hier ist eine duale Anordnung mit zusammengefaßten Y-Wortansteuerleitungen WE1, 2 und entsprechend erhöhten X-Ansteuerleitungen WBa und b gezeigt. Eine Y-Wortansteuerleitung WE ist deshalb jeweils mit den Emittern der zu einer geteilten Wortansteuerleitung, z. B. WB1a und b, gehörenden Wortschalter T1 und T2 verbunden, während dem die geteilten X-Wortansteuerleitungen WBa und b jeweils mit einer Basis dieser Wortschalter T1 und T2 verbunden sind. Damit ist gezeigt worden, daß durch das Schaltungsprinzip der Wortleitungsunterteilung in mehrere Abschnitte eine optimale Array-Unterteilung ermöglicht wird, die an die jeweiligen physikalischen (Layout) und elektrischen Parameter (Kapazitäten und Widerstände) der Speichermatrix sowie an die externen und internen Organisationen des Speicherchips angepaßt ist. Daraus ergibt sich eine wesentliche Verbesserung des Leistungs-/Geschwindigkeits-Verhältnisses des jeweiligen Speicherchips bei einem minimalen Flächenaufwand.

## Patentansprüche

1. Halbleiterspeicher mit einer Speicherzellenmatrix, die über Wort- und Bitleitungen angesteuert wird, die ihrerseits über von Adressen angesteuerten außerhalb der Speicherzellenmatrix angeordneten Decodern und Steuerleitungen, die mit Wortschaltern der Wortleitungen verbunden sind, ausgewählt werden, wobei die Wortleitungen innerhalb der Speicherzellenmatrix in N Teilwortleitungen (WL1, WL2,..., WLN) oder Abschnitte kombiniert mit jeweils einem Wortschalter (T1, T2 ...), aufgeteilt sind, die Wortschalter (T1 - TN) der Teilwortleitungen (z. B. WL1 - WLN) eines Wortes über eine innerhalb der Speicherzellenmatrix verlaufende zusätzliche erste Wortansteuerleitung (z. B. WB1) angesteuert werden, und eine innerhalb der Speicherzellenmatrix verlaufende zusätzliche zweite Wortansteuerleitung (z. B. WE1) an ein außerhalb der Speicherzellenmatrix selektiv erzeugtes Potential (z. B. 0,5 V in Fig. 1) angeschlossen wird, derart, daß nicht alle Teilwortleitungen einer Wortleitung gleichzeitig selektiert werden.

2. Halbleiterspeicher nach Anspruch 1 dadurch gekennzeichnet, daß zwei oder mehrere erste Wortansteuerleitungen (z. B. WB1 und WB2) in einer Ausdehnungsrichtung zu einer Leitung (WB1') zusammengefaßt sind, daß dann die zweiten Wortansteuerleitungen (z. B. WE1) in der anderen Ausdehnungsrichtung in eine entsprechende Anzahl (z. B. a und b) aufgeteilt und mit den entsprechenden Wortschaltern (z. B. T1 und T1') verbunden sind.

3. Halbleiterspeicher nach Anspruch 1, dadurch gekennzeichnet, daß mehrere oder zwei der zweiten Wortansteuerleitungen (z. B. WE1 und WE2) zu einer Leitung (WE1, 2) zusammengefaßt werden und mit Emittern der Transistoren der entsprechenden Wortschalter (z. B. T1 und T2) verbunden sind, während die Wortansteuerleitungen, die in der anderen Ausdehnungsrichtung verlaufen (z. B. WB1), in eine entsprechende Anzahl von Leitungen (z. B. a und b) aufgeteilt und mit den entsprechenden Wortschaltern (z. B. T1 und T2) verbunden werden.

4. Halbleiterspeicher nach den Ansprüchen 1 bis 3, dadurch gekennzeichnet, daß bei der Verwendung von bipolaren Multi-Emitter-Speicherzellen mit einem positiven Wortleitungs-Selektionsimpuls ein Widerstand (RB) zwischen der Wortansteuerleitung (z. B. WB1) in der einen Ausdehnungsrichtung von der Basis eines jeden Wortschalters (z. B. T1) zur Entkopplung von selektierten und unselektierten Wortansteuerleitungen (WE1, WE2, ..., WEN) in der anderen Ausdehnungsrichtung angeordnet ist.

5. Halbleiterspeicher nach den Ansprüchen 1 bis 4, dadurch gekennzeichnet, daß in MTL-Technik die Transistoren der Wortschalter (z. B. T1) als Minimum-Transistoren ausgeführt mit in der Wanne der Speicherzellen integriert sind.

## Claims

1. Semiconductor memory with a memory cell matrix controlled through word and bit lines which in turn are selected by decoders and control lines controlled by addresses and positioned outside the memory cell matrix and which are connected to word switches of the word lines, the word lines within the memory cell matrix being divided into N partial word lines (WL1, WL2, ..., WLN) or partitions each combined with one word switch (T1, T2 ...), the word switches (T1 - TN) of the partial word lines (e.g. WL1 - WLN) of a word being controlled by an additional first word control line (e.g. WB1) extending inside the memory cell matrix, and an additional second word control line, (e.g. WE1) extending inside the memory cell matrix, being connected to a potential (e.g. 0.5 V in Fig. 1), selectively produced outside the memory cell matrix, such that not all partial word lines of a word line are simultaneously selected.

2. Semiconductor memory according to claim 1, characterized in that two or several first word control lines (e.g. WB1 and WB2) in one direction are combined to form one line (e.g. WB1'), that the second word control lines (e.g. WE1) in the other direction are divided into a corresponding number of lines (e.g. a and b) and are connected to the associated word switches (e.g. T1 and T1').

3. Semiconductor memory according to claim 1, characterized in that several or two of the word control lines (e.g. WE1 and WE2) are combined to form one line (WE1, 2) and are connected to emitters of the transistors of the associated word switches (e.g. T1 and T2), while the word control lines in the other direction (e.g. WB1) are divided into a corresponding number of lines (e.g. a and b) and are connected to the associated word switches (e.g. T1 and T2).

4. Semiconductor memory according to claims 1 to 3, characterized in that if bipolar multi-emitter cells with a positive word line selection pulse are used, a resistor (RB) is arranged between the word control line (e.g. WB1) in one direction from the base of each word switch (e.g. T1) for decoupling selected and unselected word control lines (WE1, WE2, ..., WEN) in the other direction.

5. Semiconductor memory according to claims 1 to 4, characterized in that in MTL technology, the transistors of the word switches (e.g. T1) are designed as minimum transistors and are integrated in the cell pocket.

## Revendications

1. Mémoire à semiconducteurs comportant une matrice de cellules de mémoire, commandée par l'intermédiaire de conducteurs de transmission de mots et de conducteurs de transmission de bits, qui, pour leur part, sont sélectionnés par l'intermédiaire de décodeurs commandés par des adresses et situés à l'extérieur de la matrice de cellules de mémoire et par l'intermédiaire de conducteurs de commande de transmission de mots, qui sont reliés à des commutateurs de transmission de mots des conducteurs de transmission de mots, et dans laquelle les conducteurs de transmission de mots sont répartis à l'intérieur de la matrice de cellules de mémoire en N conducteurs partiels de transmission de mots (WL1, WL2, ..., WLN) ou sections, combinés à des commutateurs respectifs de transmission de mots (T1, T2 ...), les commutateurs de transmission de mots (T1 - TN) des conducteurs partiels de transmission de mots (par exemple WL1 - WLN) pour un mot sont commandés par l'intermédiaire d'un premier conducteur supplémentaire de commande de transmission de mots (par exemple WB1), qui s'étend à l'intérieur de la matrice de cellules de mémoire, et un second conducteur supplémentaire de commande de transmission de mots (par exemple WE1), qui s'étend à l'intérieur de la matrice de cellules de mémoire, sont raccordés à un potentiel (par exemple 0,5 V sur la figure 1), produit de façon sélective à l'extérieur de la matrice de mémoire, de sorte que les conducteurs partiels de transmission de mots d'un conducteur de transmission de mots ne sont pas tous sélectionnés simultanément.

2. Mémoire à semiconducteurs selon la revendication 1, caractérisée en ce que deux ou plusieurs premiers conducteurs de commande de transmission de mots (par exemple WB1 et WB2) sont réunis, dans une direction d'extension, pour former un conducteur (WB1'), que les seconds conducteurs de commande de transmission de mots (par exemple WE1) sont alors subdivisés, dans l'autre direction d'extension, en un nombre correspondant (par exemple a et b) et sont reliés aux commutateurs correspondants de transmission de mots (par exemple T1 et T1').

3. Mémoire à semiconducteurs selon la revendication 1, caractérisée en ce que plusieurs ou deux des seconds conducteurs de commande de transmission de mots (par exemple WE1 et WE2) sont réunis pour former un conducteur (WE1, 2) et sont reliés à des émetteurs des transistors des commutateurs correspondants de transmission de mots (par exemple T1 et T2), tandis que les conducteurs de commande de transmission de mots, qui s'étendent dans l'autre direction d'extension (par exemple WB1), sont subdivisés en un nombre correspondant de conducteurs (par exemple a et b) et sont reliés aux commutateurs correspondants de transmission de mots (par exemple T1 et T2).

4. Mémoire à semiconducteurs selon les revendications 1 à 3, caractérisée en ce que, dans le cas de l'utilisation de cellules de mémoire bipolaires à émetteurs multiples utilisant une impulsion positive de sélection des conducteurs de transmission de mots, une résistance (RB) est montée entre le conducteur de commande de transmission de mots (par exemple WB1) s'étendant dans une direction d'extension à partir de la base de chaque commutateur de transmission de mots (par exemple T1), pour réaliser le découplage de conducteurs sélectionnés et non sélectionnés de commande de transmission de mots (WE1, WE2, ..., WEN) dans l'autre direction d'extension.

5. Mémoire à semiconducteurs selon les revendications 1 à 4, caractérisée en ce que, dans la technique MTL, les transistors des commutateurs de transmission de mots (par exemple T1) sont intégrés conjointement, en étant réalisés sous la forme de transistors à minimum, dans la cuvette des cellules de mémoire.

FIG.1

FIG. 2

1

EP 0 126 784 B1

FIG. 3

FIG.4

3